(19) Europäisches Patentamt

European Patent Office

Office européen des brevets

(11) Veröffentlichungsnummer: **0 262 495 B1**

(12) **EUROPÄISCHE PATENTSCHRIFT**

(45) Veröffentlichungstag der Patentschrift: **24.07.91**

(51) Int. Cl.⁵: **G01R 33/36**

(21) Anmeldenummer: **87113338.5**

(22) Anmeldetag: **11.09.87**

(54) **Kernspin-Resonanzgerät zur Ermittlung von Spektren oder Bildern eines Untersuchungsobjektes.**

(30) Priorität: **22.09.86 DE 3632137**

(43) Veröffentlichungstag der Anmeldung:
**06.04.88 Patentblatt 88/14**

(45) Bekanntmachung des Hinweises auf die
Patenterteilung:
**24.07.91 Patentblatt 91/30**

(84) Benannte Vertragsstaaten:
**DE GB NL**

(56) Entgegenhaltungen:
**EP-A- 0 164 164**
**EP-A- 0 170 514**
**DE-A- 3 427 666**
**GB-A- 2 153 086**
**GB-A- 2 161 940**

**PATENT ABSTRACTS OF JAPAN, Band 8, Nr.
175(P-294)[1612], 11. August 1984 & JP-
A-59-70 950**

**RADIOLOGY, Band 157, Nr. 2, November
1985, Seiten 449-452, Easton, US; E.B. BOS-
KAMP: "Improved surface coil imaging in
MR: decoupling of the excitation and receiver coils"**

(73) Patentinhaber: **Siemens Aktiengesellschaft
Wittelsbacherplatz 2
W-8000 München 2(DE)**

(72) Erfinder: **Meissner, Ralph, Dipl.-Ing.
Paul-Gossen-Strasse 34
W-8520 Erlangen(DE)**
Erfinder: **Kess, Helmut, Dipl.-Ing. (FH)
Hopfenstrasse 28
W-8360 Deggendorf(DE)**

## Beschreibung

Die Erfindung betrifft ein Kernspin-Resonanzgerät zur Ermittlung von Spektren oder Bildern eines Untersuchungsobjektes mittels der kernmagnetischen Resonanz mit Spulen zum Anlegen von magnetischen Grund- und Gradientenfeldern an das Untersuchungsobjekt, mit einer Ganzkörperantenne, mit der das Untersuchungsobjekt mit einer Folge von Hochfrequenzimpulsen mit der Wellenlänge λ bestrahlt wird und mit einer Oberflächenspule, die die vom Untersuchungsobjekt ausgesandten Kernresonanzsignale erfaßt, wobei die Ganzkörperantenne und die Oberflächenspule voneinander entkoppelt werden.

Für die Untersuchung einzelner Körperbereiche mit Hilfe der kernmagnetischen Resonanz werden vielfach Oberflächenspulen eingesetzt, da sie durch einen Anstieg im Signal-/Rausch-Verhältnis die räumliche Auflösung im Empfindlichkeitsbereich der Oberflächenspule verbessern. Bevorzugt wird dabei mit einer den gesamten Untersuchungsraum erfassenden Ganzkörperantenne gesendet, um ein bezüglich der HF-Anregung möglichst homogenes Signal im Bereich der Oberflächenspule zu erzeugen. Die von den Kernen abgegebenen Signale werden dann mit der Oberflächenspule empfangen, wobei deren Homogenität dann nur noch eine untergeordnete Rolle spielt.

Da die Ganzkörperantenne und die Oberflächenspule auf die gleiche Resonanzfrequenz abgestimmt sind, müssen diese gegenseitig entkoppelt werden, um die gegenseitige Beeinflussung zu verhindern. Wenn die Ganzkörperantenne ein linear polarisiertes Feld bildet, kann das Feld der Oberflächenspule senkrecht zum Feld der Ganzkörperantenne ausgerichtet sein. Damit ist aber die Lage der Oberflächenspule bezüglich der Ganzkörperantenne fixiert und nicht, z.B. zur Anpassung an die anatomischen Gegebenheiten, frei orientierbar. Bei einer zirkular polarisierten Ganzkörperantenne ist eine Entkoppelung von Oberflächenspule und Ganzkörperantenne auf diese Weise nicht möglich.

Aus dem Artikel von Boskamp, Radiology, Band 157, Nr. 2, Seiten 449-452 ist es bekannt, die Oberflächenspule mit Hilfe von Abstimm-Dioden (Varicaps) zu verstimmen, während die Ganzkörperantenne in Betrieb ist. Während des Betriebes der Oberflächenspule wird mit Hilfe einer Dioden-Brücke aus PIN-Dioden die Ganzkörperantenne kurzgeschlossen.

Bei dieser bekannten Lösung ist jedoch die Gefahr, daß die Maßnahmen, die zur Entkoppelung vorgesehen sind, die Ganzkörperantenne auch während des Sende- bzw. Empfangsbetriebes beeinflussen bzw. deren Eigenschwingkreisgüte verschlechtern, sehr groß.

Weiterhin genügt es nicht, die Entkoppelung der Oberflächenspule durch Verstimmen zu höheren Frequenzen zu realisieren. An dem hohen Resonanzwiderstand entsteht durch HF-Einkoppelung von der Ganzkörperantenne eine hohe Spannung, die die Abstimm-Dioden (Varicaps) zerstören kann.

Aus der DE-A-1-34 27 666 ist eine Schaltungsanordnung zur Entkoppelung der einzelnen Spulen eines Mehrspulenmeßkopfes eines Kernspin-Resonanzgerätes bekannt. Dabei ist eine Sendespule über eine λ/2-Leitung und eine in Serie liegende Antiparallelschaltung zweier Dioden an einen Sender angeschlossen. Die Empfangsspule ist über eine λ/4-Leitung an einen Empfänger angeschlossen, dessen Eingang eine Antiparallelschaltung zweier Dioden parallel geschaltet ist.

Während des Sendens gibt die Empfangsspule eine hohe Spannung ab, die die Schwellen der dem Empfängereingang parallel geschalteten Dioden übersteigt, so daß diese leitend werden und die anstehende Spannung auf die Schwellspannung begrenzt.

Während des Empfangsbetriebs werden die dem Empfängereingang parallel geschalteten Dioden aufgrund der wesentlich schwächeren Signale nicht leitend. Die während des Empfangsbetriebs von der Sendespule aufgenommenen Signale erreichen auch nicht die Schwellwerte der dem Sender vorgeschalteten Dioden.

Auch bei dieser Schaltung ist jedoch aufgrund der Dioden-Schwellspannungen keine vollständige Entkoppelung gewährleistet. Eine Entkoppelung für zwei Spulen ist aus EP-A-170514 bekannt.

Aufgabe der Erfindung ist es daher, eine Entkoppelungsvorrichtung der eingangs genannten Art so auszuführen, daß der Einfluß auf den zugeordneten Resonanzkreis besonders bei der Ganzkörperantenne außerhalb der Verstimmmungsphasen gering bleibt und zu diesem Zeitpunkt in der Oberflächenspule kein Strom fließen kann.

Diese Aufgabe wird erfindungsgemäß dadurch gelöst, daß an die Ganzkörperantenne über eine Koaxialleitung eine λ/4-Leitung angeschlossen wird, dessen Ende beim Aussenden von HF-Impulsen mit der Ganzkörperantenne kurzgeschlossen und beim Empfang von Kernresonanzsignalen mit der Oberflächenspule geöffnet ist, wobei die Koaxialleitung die hohe Impedanz der Ganzkörperantenne auf ein niedriges Niveau transformiert. Mit der λ/4-Leitung steht ein einfaches und billiges Mittel zur Verstimmung des zugeordneten Resonanzkreises zur Verfügung, das außerdem im geschlossenen Zustand den Resonanzkreis nur sehr wenig beeinflußt.

Durch die Transformation der hohen Impedanz der Ganzkörperantenne auf ein niedriges Niveau wird der Einfluß des geschlossenen λ/4-Leitung auf die Eigengüte des zugeordneten Resonanzkreises noch weiter verringert. Dies hat außerdem den Vorteil, daß damit auch die Spannung an der Ganzkörperantenne heruntertransformiert wird, wobei die dann entstehenden Strome leichter zu handhaben sind als hohe Spannungen.

Das Kurzschließen der λ/4-Leitung kann in einer einfachen Ausführungsform durch mindestens eine an deren Ende angeschlossene PIN-Diode erfolgen.

Ein Ausführungsbeispiel der Erfindung wird nachfolgend anhand der Figuren 1-4 näher erläutert.

Figur 1    zeigt schematisch den Aufbau eines Kernspin-Resonanzgerätes,

Figur 2    zeigt ein Ausführungsbeispiel der Erfindung,

Figur 3    zeigt ein Ausführungsbeispiel für den Schalter 21,

Figur 4    zeigt den Gleichstromkreis für zwei Schalter 21,21' und

Figur 5    zeigt ein Ausführungsbeispiel für die Entkoppelung der Oberflächenspule 19.

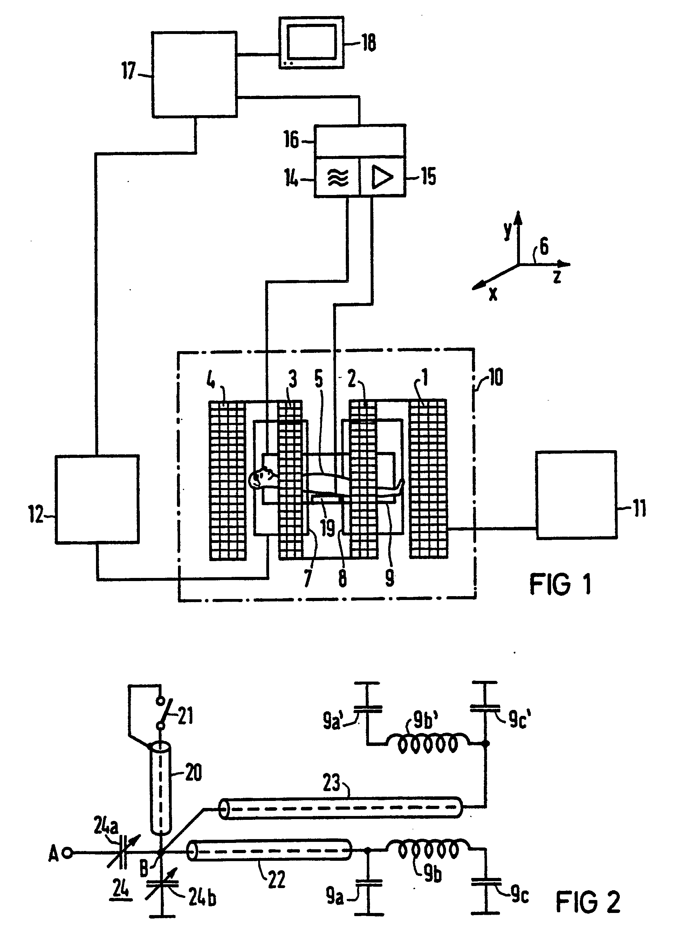

Figur 1 zeigt schematisch den prinzipiellen Aufbau eines Kernspin-Resonanzgerätes, in diesem Fall eines Kernspin-Tomographiegerätes für die Erstellung von Schnittbildern eines Untersuchungsobjektes. Mit 1 und 2 sowie 3 und 4 sind Spulen bezeichnet, die ein magetisches Grundfeld $B_0$ erzeugen, in welchem sich bei Anwendung zur medizinischen Diagnostik der zu untersuchende Körper 5 eines Patienten befindet. Diesem sind außerdem Gradientenspulen zugeordnet, die zur Erzeugung unabhängiger, zueinander senkrechter Magnetfeldgradienten der Richtungen x,y und z gemäß dem Koordinatenkreuz 6 vorgesehen sind. In der Figur sind der Übersichtlichkeit halber nur die Gradientenspulen 7 und 8 gezeichnet, die zusammen mit einem Paar gegenüberliegender, gleichartiger Gradientenspulen zur Erzeugung des x-Gradienten dienen. Die gleichartigen, nicht gezeichneten y-Gradientenspulen liegen parallel zum Körper 5 und oberhalb sowie unterhalb von ihm, die für das z-Gradientenfeld quer zu seiner Längsachse am Fuß- und am Kopfende. Die Anordnung enthält außerdem noch eine zur Erzeugung der Kernresonanzsignale dienende Ganzkörperantenne, in diesem Fall einen Körperresonator 9, sowie eine zur Aufnahme der Kernresonanzsignale dienende Oberflächenspule 19.

Die von einer strichpunktierten Linie 10 umgrenzten Spulen 1,2,3,4,7,8 und 9 stellen das eigentliche Untersuchungsinstrument dar. Es wird von einer elektrischen Anordnung aus betrieben, die ein Netzgerät 11 zum Betrieb der Spulen 1-4 sowie eine Gradientenstromversorgung 12, an welcher die Gradientenspulen 7 und 8 sowie die weiteren Gradientenspulen liegen, umfaßt. Ein von einem Prozeßrechner 17 gesteuerter Hochfrequenzsender 14 ist mit dem Körper-Resonator 9 verbunden. Die Oberflächenspule 19 ist über einen Signalverstärker 15 ebenfalls an den Prozeßrechner 17 gekoppelt, an dem zur Ausgabe einer Abbildung ein Bildschirmgerät 18 angeschlossen ist. Die Komponenten 14 und 15 bilden eine Hochfrequenzeinrichtung 16 zur Signalerzeugung und -aufnahme.

In Figur 2 ist ein Ausführungsbeispiel einer Entkoppelungseinrichtung für den Körper-Resonator 9 dargestellt. Die Erfindung läßt sich beispielsweise auf einen Körper-Resonator, wie er in der DE-A1-31 33 432 beschrieben ist, vorteilhaft anwenden. Dabei besteht der Körper-Resonator im einfachsten Fall aus einem Paar entgegengesetzt stromdurchflossener Stäbe. Diese Stäbe sind in Figur 2 durch ihr Ersatzschaltbild mit jeweils zwei Kondensatoren 9a,9c bzw. 9a',9c' und einer diese verbindenden Induktivität 9b bzw. 9b' angedeutet. Die Stäbe 9 werden über eine Koaxialleitung 22 bzw. 23 an eine Anpaßschaltung 19 angeschlossen. Dabei ist darauf zu achten, daß die Koaxialleitungen 22 und 23 elektrisch die gleiche Länge aufweisen, damit die Phasenbedingungen zwischen den beiden Stäben gewahrt bleiben.

Die Ankoppelschaltung 24 enthält einen abstimmbaren Serienkondensator 24a und einen ebenfalls abstimmbaren Parallelkondensator 24b. Mit Hilfe dieser Kondensatoren 24a,24b kann das am Punkt A angeschlossene Speisekabel an den Körper-Resonator 9 angepaßt werden.

Am Anschlußpunkt B der Koaxialleitungen 22,23 ist die λ/4-Leitung, in diesem Fall eine Koaxialleitung, angeschlossen. Deren Ende kann durch einen Schalter 21 zwischen Innenleiter und Mantelleiter kurzgeschlossen werden.

Wenn sich der Körper-Resonator 9 im Sendebetrieb befindet, wird der Schalter 21 geschlossen. Das damit kurzgeschlossene λ/4-Kabel 20 hat dann nur einen sehr geringen Einfluß auf den Resonanzkreis des Körper-Resonators 9. Dabei ist besonders vorteilhaft, daß das λ/4-Kabel nicht direkt an den Körper-Resonator 9 geschaltet ist, sondern am Ende der Koaxialleitungen 22,23, die die hohe Impedanz des Körper-Resonators 9 auf ein niedrigeres Niveau transformieren. Dabei ist es außerdem vorteilhaft, daß der Schalter 21 nunmehr nicht mehr mit hohen Spannungen, sondern über das λ/4-Kabel mit entsprechend höheren Strömen beaufschlagt wird. Dies ist jedoch bei Hochfrequenzschaltern leichter zu bewältigen. Als besonders günstig für die Impedanztransformation hat sich eine elektrische Länge der Koaxialleitungen 22,23 von 3/8 λ erwiesen.

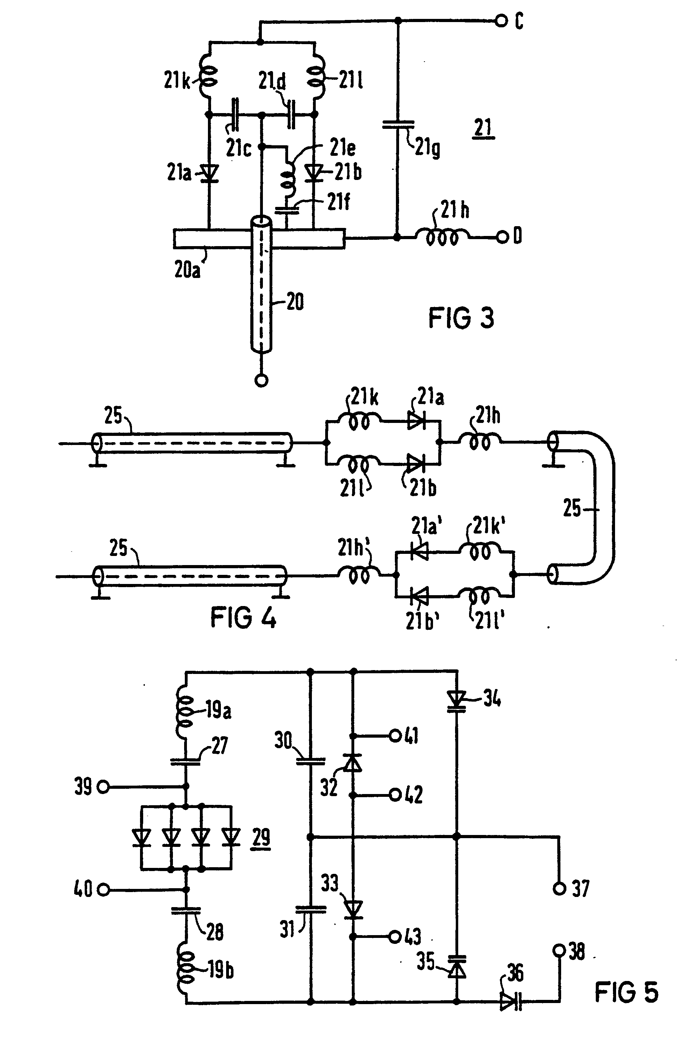

Figur 3 zeigt ein Ausführungsbeispiel des Schalters 21. Dabei wird der Mantelleiter 20 der λ/4-Leitung an einen Kupferklotz 20a gelegt, an den die Kathoden zweier PIN-Dioden 21a und 21b angeschlossen sind. Die Anoden der PIN-Dioden sind über jeweils einen Kondensator 21c bzw. 21d mit dem Innenleiter der $\lambda$/4-Leitung 20 und über eine Drossel 21k bzw. 21l mit einem Anschluß C für einen Steuer-Gleichstrom verbunden. Der zweite Anschluß D für den Steuer-Gleichstrom ist über eine Drossel 21h mit dem Kupferklotz 20a verbunden. Ferner ist der Anschluß C über einen Kondensator 21g mit dem Verbindungspunkt von Kupferklotz 20a und Drossel 21h verbunden. Schließlich weist die Anordnung noch einen Serien-Schwingkreis mit einer Induktivität 21e und einem Kondensator 21f zwischen Innenleiter der $\lambda$/4-Leitung 20 und Kupferklotz 20a auf. Mit diesem Serien-Schwingkreis kann eine Optimierung der Körper-Resonator-Verstimmung (maximale Pegeldifferenz zwischen Resonanz und Verstimmung) vorgenommen werden, wenn der Schalter geöffnet ist.

Solange die Klemmen C,D nicht mit einem Gleichstrom beaufschlagt werden, sperren die PIN-Dioden 21a und 21b. Damit ist also die $\lambda$/4-Leitung 20 offen, so daß der Körper-Resonator 9 verstimmt wird. Während des Sendebetriebes des Körper-Resonators 9 werden die Klemmen C,D mit Gleichstrom beaufschlagt, so daß die PIN-Dioden 21a und 21b leitend werden. Damit wird über die Kondensatoren 21c und 21d die $\lambda$/4-Leitung 20 kurzgeschlossen. Dabei wird der Strom auf die beiden PIN-Dioden 21a und 21b aufgeteilt, da eine einzelne PIN-Diode in der Praxis nicht die erforderliche Belastbarkeit aufweist. Zusätzlich wird der Kurzschluß am Ende der $\lambda$/4-Leitung verbessert.

Mit den Drosseln 21k,21l,21h und dem Kondensator 21g wird verhindert, daß die Hochfrequenz auf die Gleichstromleitungen (Steuerleitungen) übertragen wird.

Für zirkularpolarisierte Felder werden, wie in der bereits genannten DE-A1-31 33 432 beschrieben, mindestens zwei Paare von Stäben für den Körper-Resonator 9 benötigt. Dabei ist für jedes Leiterpaar eine $\lambda$/4-Leitung 20 mit einem Schalter 21 vorgesehen. Die Schalter 21 können dabei gleichstrommäßig in Reihe geschaltet werden.

Figur 4 zeigt den für den Gleichstrom wirksamen Kreis der Schalter 21,21h. Dabei sind die Schalter 21a,b und 21a',b' über eine abgeschirmte Leitung 25 gleichstrommäßig in Reihe geschaltet. Durch die Drosseln 21h,21k und 21l sowie 21h',21k' und 21l' wird verhindert, daß die gleichstrommäßige Verbindung sich auf die Hochfrequenz auswirkt.

Figur 5 zeigt ein Ausführungsbeispiel zur Unterbrechung des Resonanzkreises der Oberflächenspule 19 bei Anregung des Untersuchungsobjektes mit dem Körperresonator 9. Dabei ist die Oberflächenspule 19 in zwei gleiche Teile 19a,19b aufgeteilt, die über die Reihenschaltung eines Kondensators 27, einer Parallelschaltung von vier PIN-Dioden 29 und eines weiteren Kondensators 28 miteinander verbunden sind. Parallel zur Oberflächenspule 19 ist außerdem die Reihenschaltung zweier Kondensatoren 30 und 31, zweier Schutzdioden 32 und 33 und zweier Abstimmdioden 34 und 35 angeordnet. Der Abgriff der Signalspannung erfolgt am Verbindungspunkt der beiden Kondensatoren 30 und 31 über eine Anschlußklemme 37 und am Verbindungspunkt der Oberflächenspule 19 mit dem Kondensator 31 über eine Anpaßdiode 36 und eine Anschlußklemme 38. Durch die Abstimmdioden 34 und 35 wird die Resonanzfrequenz der Oberflächenspule 19 an die Signalfrequenz angepaßt. Mit der Anpaßdiode 36 erfolgt eine Anpassung der Anordnung an den Wellenwiderstand der Anschlußleitung. Dazu werden die Abstimmdioden 34 und 35 und die Anpaßdiode 36 mit einer der Übersichtlichkeit wegen nicht dargestellten Steuer-Gleichspannung beaufschlagt.

Im Sendebetrieb, d.h. bei Anregung des Untersuchungsobjektes mit dem Körperresonator 9, wird der Resonanzkreis der Oberflächenspule 19 aufgetrennt, indem die PIN-Dioden 29 über die Klemmen 39 und 40 mit einer Sperr-Gleichspannung beaufschlagt werden.

Damit wird verhindert, daß ein Induktionsstrom fließt, der das Anregungsfeld beeinflußt. Die Auftrennung des Resonanzkreises erfolgt an der HF-mäßig niederohmigsten Stelle, so daß die PIN-Dioden 29 spannungsmäßig nur gering beansprucht werden. Im Sendebetrieb werden außerdem die Abstimmdioden 34 und 35 durch die entgegengesetzt geschalteten Schutzdioden 32,33, die im Durchgang betrieben werden, vor Überspannungen geschützt.

Im Empfangsfall werden die PIN-Dioden 29 nicht mehr mit einer Sperrspannung beaufschlagt, d.h. sie sind im Durchgang betrieben und stellen somit einen Kurzschluß dar. Über eine Sperrspannung an den Klemmen 41 bis 43 werden die Schutzdioden 32 und 33 mit einer Sperr-Gleichspannung beaufschlagt, so daß diese unwirksam werden. Damit ist die Oberflächenspule in Resonanz mit dem Kernspin-Resonanzsignal.

**Patentansprüche**

1. Kernspin-Resonanzgerät zur Ermittlung von Spektren oder Bildern eines Untersuchungsobjektes mittels der kernmagnetischen Resonanz mit Spulen (1,2,3,4,7,8) zum Anlegen von magnetischen Grund- und Gradientenfeldern an das Untersuchungsobjekt (5), mit einer Ganzkörperantenne (9), mit der das Untersuchungsobjekt (5) mit einer Folge von Hochfrequenzimpulsen mit der Wellenlänge $\lambda$ bestrahlt wird und mit einer Oberflächenspule (19), die die vom Untersuchungsobjekt (5) ausgesandten Kernresonanzsignale erfaßt, wobei die Ganzkörperantenne (9) und die Oberflächenspule (19) voneinander entkoppelt werden,
**dadurch gekennzeichnet,**
daß an die Ganzkörperantenne (9) über eine Koaxialleitung (22,23) eine λ/4-Leitung (20) angeschlossen wird, dessen Ende beim Aussenden von HF-Impulsen mit der Ganzkörperantenne (9) kurzgeschlossen und beim Empfang von Kernresonanzsignalen mit der Oberflächenspule (19) geöffnet ist, wobei die Koaxialleitung (22,23) die hohe Impedanz der Ganzkörperantenne (9) auf ein niedriges Niveau transformiert.

2. Kernspin-Resonanzgerät nach Anspruch 1,
**dadurch gekennzeichnet,**
daß das Kurzschließen der λ/4-Leitung (20) durch mindestens eine an deren Ende angeschlossene PIN-Diode (21a,21b) erfolgt.

3. Kernspin-Resonanzgerät nach Anspruch 1 oder 2,
**dadurch gekennzeichnet,**
daß ein Resonanzkreis der Oberflächenspule (19) einen den Resonanzkreis verstimmenden Schalter (29) enthält, der während des Sendebetriebs der Ganzkörperantenne (9) offen ist.

**Claims**

1. A nuclear spin resonance apparatus for detecting spectra or images of an object under examination by means of nuclear magnetic resonance with coils (1,2,3,4,7,8) for applying magnetic base and gradient fields to the object under examination (5), with a whole-body antenna (9), with which the object under examination (5) is irradiated with a series of high frequency pulses with the wave length λ and with a surface coil (19), which detects nuclear resonance signals emitted by the object under examination (5), wherein the whole-body antenna (9) and the surface coil (19) are decoupled from each other,
characterised in that connected to the whole-body antenna (9) by way of a coaxial line (22,23) there is a λ/4 line (20), the end of which is short-circuited, when emitting HF pulses, with the whole-body antenna (9), and when receiving the nuclear resonance signals, is opened with the surface coil (19), wherein the coaxial line (22,23) transforms the high impedance of the whole-body antenna (9) to a low level.

2. A nuclear spin resonance apparatus according to claim 1, characterised in that the short-circuiting of the λ/4 line (20) occurs by at least one p-i-n diode (21a, 21b) connected to the end thereof.

3. A nuclear spin resonance apparatus according to claim 1 or 2, characterised in that a resonant circuit of the surface coil (19) contains a switch (29) detuning the resonant circuit, which is open during the transmitting operation of the whole-body antenna (9).

**Revendications**

1. Appareil de résonance magnétique nucléaire pour la détermination de spectres ou d'images d'un objet d'examen à l'aide de la résonance magnétique nucléaire, comportant des bobines (1,2,3,4,7,8) servant à appliquer un champ magnétique de base et des champs magnétiques irrotationnels à l'objet d'examen (5), une antenne (9), qui s'étend sur l'ensemble du corps et au moyen de laquelle l'objet d'examen (5) est irradié au moyen d'une suite d'impulsions de haute fréquence ayant pour longueur d'onde λ, et comportant une bobine plate (19), qui détecte les signaux de résonance nucléaire émis par l'objet d'examen (5), l'antenne (9), qui s'étend sur l'ensemble du corps, et la bobine plate (19) étant découplées l'une par rapport à l'autre,
caractérisé par le fait que l'antenne (9), qui s'étend sur l'ensemble du corps, est raccordée au moyen d'un câble coaxial (22,23) à une ligne λ/4 (20), dont l'extrémité est court-circuitée lors de l'émission de l'impulsion HF par l'antenne (9), qui s'étend sur l'ensemble du corps, et est ouverte lors de la réception de signaux de résonance magnétique nucléaire par la bobine plate (19), le câble coaxial (22,23) transformant l'impédance élevée de l'antenne (9) en l'amenant à un niveau faible.

2. Appareil de résonance magnétique nucléaire suivant la revendication 1, caractérisé par le fait que le court-circuitage de la ligne λ/4 (20) est réalisé à l'aide d'au moins une diode PIN (21a, 21b), raccordée à l'extrémité de la ligne (20).

3. Appareil de résonance magnétique nucléaire suivant la revendication 1 ou 2, caractérisé par le fait qu'un circuit résonnant de la bobine plate (19) comporte un interrupteur (29), qui désaccorde le circuit résonnant et qui est ouvert pendant le fonctionnement en émission de l'antenne (9), qui s'étend sur l'ensemble du corps.

FIG 1

FIG 2

FIG 3

FIG 4

FIG 5